# EUROPEAN PATENT APPLICATION

(11) **EP 1 635 356 A1**
(43) Date of publication of application: **15.03.2006**
(21) Application number: 05019580.9
(22) Date of filing: 08.09.2005
(51) Int. Cl.: G11C 11/16

(54) **Magnetic memory with magnetic yoke**

(30) Priority: 10.09.2004 JP 2004264450
(71) Applicant: TDK Corporation, Tokyo 103-8272 (JP)
(72) Inventor: Koga, Keiji, c/o TDK Corporation, Chuo-ku, Tokyo 103-8272 (JP); Ezaki, Joichiro, c/o TDK Corporation, Chuo-ku, Tokyo 103-8272 (JP)
(74) Representative: Grünecker, Kinkeldey, Stockmair & Schwanhäusser Anwaltssozietät

(57) **Abstract**

Each of a plurality of memory areas 3 provided in a magnetic memory 1 includes a TMR (tunneling magnetoresistive) element 4 having a first magnetic layer 41 of which magnetization direction A is changed by an external magnetic field; write wiring 31 for supplying the external magnetic field to the first magnetic layer 41 by means of a write current; a magnetic yoke 5 disposed so as to surround the periphery of the write wiring 31, being formed of an approximate ring shape having a pair of end faces 5a disposed face-to-face with a gap intervening therebetween; and a write transistor 32 for controlling conduction of the write current. The TMR element 4 is disposed so that a pair of side faces 4a thereof is positioned face-to-face to the pair of end faces 5a of the magnetic yoke 5.

## Description

### BACKGROUND OF THE INVENTION

### Field of the Invention

The present invention relates to a magnetic memory for storing data in magnetoresistive effect elements.

### Related Background of the Invention

In recent years, attention is paid to MRAM (magnetic random access memory) as a memory device for use in information processing equipment such as computers and communication equipments. Since MRAM stores data by means of magnetism, there is no inconvenience of losing information in the MRAM due to a power break, as happens in a volatile memory such as DRAM (dynamic random access memory) and SRAM (static RAM). Further, as compared with conventional nonvolatile storage means such as the flash EEPROM and hard disk unit, the MRAM has excellent features in regard to access speed, reliability, power consumption, etc. Therefore, the MRAM has future possibilities of thoroughly replacing the functions of the volatile memory including DRAM and SRAM, and the functions of the nonvolatile storage means including EEPROM and the hard disk unit. At present, there has rapidly been developed information processing equipment aiming at so-called ubiquitous computing, enabling information processing at anytime, anywhere. It is expected that the MRAM will play a role of key device in such information processing equipment.

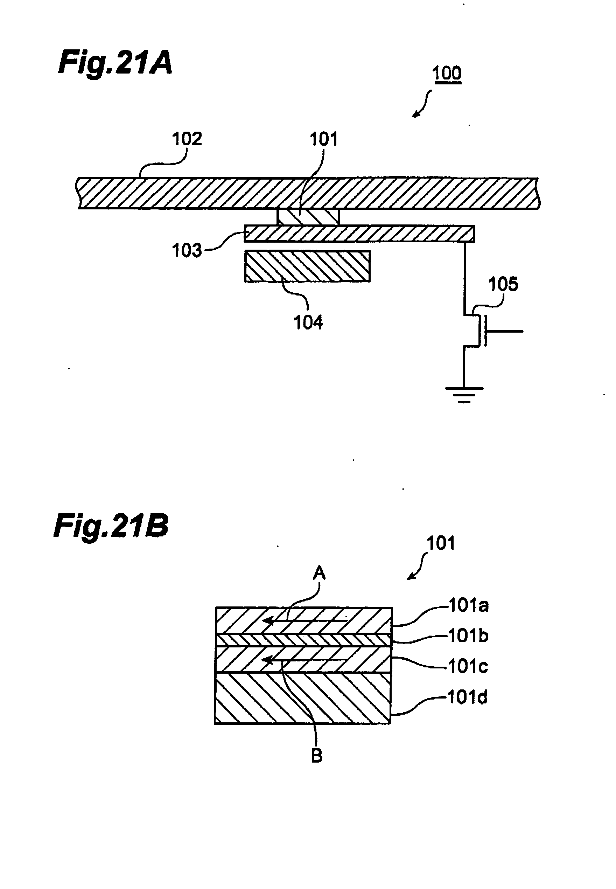

FIG. 21A shows a side cross-sectional view illustrating an exemplary structure of one memory area 100 in the conventional MRAM. The conventional MRAM has a plurality of wirings 102 extending in one direction, and a plurality of wirings 104 each extending in a direction intersecting the wiring 102, respectively. The memory area 100 is formed in each region in which the wiring 102 intersects the wiring 104. Each memory area 100 includes a tunneling magnetoresistive element 101 (hereafter referred to as TMR elecnent) which utilizes the tunneling magnetoresistive (TMR) effect. As shown in FIG. 21B, the TMR element 101 includes a first magnetic layer (magnetosensitive layer) 101a of which magnetization direction A is changed by an external magnetic field, a second magnetic layer 101c having a fixed magnetization direction B by means of an antiferromagnetic layer 101d, and a nonmagnetic insulating layer 101b being sandwiched between the first magnetic layer 10 a and the second magnetic layer 101c. By means of a synthetic magnetic field produced from the wirings 102 and 104, the magnetization direction A of the first magnetic layer 101a is controlled to be in parallel or antiparallel to the magnetization direction B, and thereby a binary data, 0 or 1, is stored in the TMR element 101. Here, the resistance value of the TMR element 101 in the thickness direction differs by whether the magnetization direction A of the first magnetic layer 101a is parallel or antiparallel to the magnetization direction B of the second magnetic layer 101c. Therefore, when reading out the binary data from the TMR element 101, a transistor 105 is set to a conduction state, so as to make a current flow from the wiring 102 being connected to the first magnetic layer 101 a to the wiring 103 being connected to the second magnetic layer 101c. Based on the current value at this time, or the potential difference between the first magnetic layer 101 a and the second magnetic layer 101c, it is decided which of the binary values is recorded.

However, the MRAM structure shown in FIGS. 21A and 21B has the following problem. Namely, in the above MRAM, it is desirable that the magnetization direction A of the first magnetic layer 101a be reversed only in the TMR element 101 to which the magnetic field is produced from both the wiring 102 and the wiring 104. However, the wirings 102 and 104 supply the magnetic field to the entire TMR elements 101 disposed along the respective extending wiring directions. As a result, also in other TMR elements 101 than the TMR element 101 into which the binary data are to be written, there is a risk of the magnetization direction A of the first magnetic layer 101a being inconrectly reversed due to the magnetic field produced from the wiring 102 or 104.

As a technique for preventing such incorrect data writing, there is a magnetic memory disclosed, for example, in the Patent Document 1. The above disclosed magnetic memory includes TMR element, wiring (a cell bit line) for making a write current flow into the TMR element, and a transistor being connected to the cell bit line. By controlling the write current for writing a binary data into the TMR element by means of the transistor, a magnetic field is supplied only to the TMR element into which the binary data is to be written.

[Patent document 1] Japanese Patent Application Laid-open No. 2004-153,182

However, the structure disclosed in the above Patent document 1 has the following problem. That is, when the write current to the TMR element is large, the transistor provided in each memory area is compelled to be large in size. This results in a large size of the overall magnetic memory, which is not practical for use. On the contrary, when the size of the TMR element is reduced so as to miniaturize the magnetic memory, the demagnetizing field is increased because of a reduced ratio of the length L to the thickness T of the first magnetic layer (L/T). This necessitates an increase of the external magnetic field intensity required for reversing the magnetization direction in the first magnetic layer, which requires a larger write current. Thus, if the size of one component between the TMR element and the transistor is reduced, the size of the other component has to be increased, which becomes a cause to impede miniaturization of the magnetic memory. Additionally, in the magnetic memory disclosed in the above Patent document 1, a yoke is formed on a cell bit line disposed on the opposite side to the TMR element side. However, such a structure is not yet sufficient for reducing the write current.

### SUMMARY OF THE INVENTION

Considering the aforementioned problem, it is an object of the present invention to provide a magnetic memory capable of preventing incorrect writing with a reduced write current.

In order to solve the aforementioned problems, a first magnetic memory according to the present invention includes a plurality of memory areas, each of which includes a magnetoresistive effect element having a magnetosensitive layer of which magnetization direction is changed by an external magnetic field; a write wiring for supplying the external magnetic field to the magnetosensitive layer by means of a write current; a magnetic yoke which is formed of an approximate ring shape having at least a pair of open end portions disposed face-to-face with a gap of a predetermined length intervening therebetween, and disposed so as to surround the periphery of the write wiring at a portion of the write wiring in its extending direction; and a write switch means for controlling conduction of the write current in the write wiring, wherein the magnetoresistive effect element is disposed so that each of a pair of side faces of the magnetoresistive effect element is positioned face-to-face or in contact with each of the pair of open end portions of the magnetic yoke, respectively.

Further, a second magnetic memory according to the present invention includes a plurality of memory areas, and each of a plurality of memory areas includes a magnetoresistive effect element having a magneto sensitive layer of which magnetization direction is changed by an external magnetic field; a write wiring for supplying the external magnetic field to the magnetosensitive layer by means of a write current; a magnetic yoke formed of an approximate ring shape, being disposed so as to continuously surround the periphery of the write wiring at a portion of the write wiring in its extending direction; and a write switch means for controlling conduction of the write current in the write wiring, wherein the magnetosensitive layer of the magnetoresistive effect element is constituted of a portion of the magnetic yoke.

In the above-mentioned first and second magnetic memories, the magnetic yoke is formed of an approximate ring shape, and disposed so as to surround the periphery of the write wiring at a portion of the write wiring in its extending direction. Because the write wiring is surrounded by the magnetic yoke, it becomes possible to reduce the magnetic field going out to a direction deflecting from the magnetoresistive effect element. Further, in the first magnetic memory, because the magnetic yoke has a pair of open end portions respectively disposed face-to-face or in contact with a pair of side faces of the magnetoresistive effect clement, it becomes possible to efficiently supply the magnetosensitive layer of the magnetoresistive effect element with the magnetic field inside the magnetic yoke (which is an external magnetic field when viewed from the magnetoresistive effect element) constituting a closed path in the direction of the periphery of the write wiring. Also, in the second magnetic memory, because the magnetosensitive layer of the magnetoresistive effect element is formed of a portion of the magnetic yoke surrounding the periphery of the write wiring, it becomes possible to efficiently supply the external magnetic field to the magnetosensitive layer of the magnetoresistive effect element. As such, according to the above magnetic memories, the external magnetic field produced by the write current can be supplied efficiently to the magnetoresistive effect element. Accordingly, the magnetization direction in the magnetosensitive layer of the magnetoresistive effect element can be reversed by means of a small write current.

Also, according to the above-mentioned magnetic memories, because the magnetization direction in the magnetosensitive layer can be reversed by the small write current, the write switch means for controlling conduction of the write current can be miniaturized, making it possible to dispose the write switch means on each memory area. Thus, virtually, it becomes possible to supply the external magnetic field only to the magnetoresistive effect element of the memory area into which data is to be written, enabling prevention of incorrect writing onto other memory areas.

Further, the first magnetic memory may be structured such that the cross section area of the magnetic yoke perpendicular to the surrounding direction is the smallest at the pair of open end portions. With this, it becomes possible to supply the magnetosensitive layer of the magnetoresistive effect element with the external magnetic field produced by the write current more efficiently.

Also, in the first magnetic memory, preferably, the easy-to-magnetize axis direction of the magnetic yoke runs along the easy-to-magnetize axis direction of the mapetosensitive layer.

Still further, in each of the first and second magnetic memories, a plurality of memory areas may be arrayed in a two-dimensional form constituted of m rows and n columns (where m, n are integers of 2 or more). The magnetic memory may further include a first wiring which is provided correspondingly to each column of a plurality of memory areas, and connected to the write wiring provided in each memory area of the corresponding column; and a second wiring which is provided correspondingly to each row of a plurality of memory areas, and connected to a control terminal of the write switch means provided in each memory area of the corresponding row.

For example, when the write current is made to flow into the first wiring corresponding to an i-th column (1 ≤ i ≤ n) including the memory area into which the data is to be written and also conduction is made to the entire write switch means being connected to the second wiring corresponding to a j-th row (1 ≤ j ≤ m) including the above memory area, the write current flows in the write wiring of this memory area corresponding to the j-th row and the i-th column, and the external magnetic field produced by the above write current is supplied to the magnetoresistive effect element. As such, according to the above-mentioned magnetic memories, it becomes possible to select each memory area into which the data is to be written with a simple structure and operation.

Further, each of the first and the second magnetic memories may include a write current generation means for supplying a positive and a negative write current to the write wiring. According to the above magnetic memory, by supplying either a positive or a negative write current from the write current generation means depending on the need, it becomes possible to appropriately reverse the magnetization direction in the magnetosensitive layer in the magnetoresistive effect element.

Further, in the first and the second magnetic memories, each of a plurality of memory areas may include a readout wiring electrically connected to the magnetoresistive effect element, for making a readout current flow into the magnetoresistive effect element; and a readout switch means for controlling conduction of the readout current in the readout wiring.

Thus, the magnetic memory according to the present invention can prevent incorrect writing, and reduce the write current as well.

### BRIEF DESCRIPTION OF THE DRAWINGS

FIG. 1 is a conceptual diagram of an overall structure of a magnetic memory according to one embodiment of the present invention.

FIG 2 is an enlarged cross-sectional view illustrating a cross-sectional structure when being cut along the row direction of the memory section.

FIG 3 is an enlarged cross-sectional view of the memory section when being cut along the line I - I shown in FIG. 2.

FIG. 4 is an enlarged cross-sectional view of the memory section when being cut along the line II - II shown in FIG 2.

FIG 5 is a cross-sectional view of a TMR element and the surrounding structure thereof along the row direction of the memory area.

FIG 6 is a cross sectional view of a TMR element and the surrounding structure thereof along the column direction of the memory area.

FIG 7A is a diagram illustrating the operation of the TMR element and its surroundings in the memory area, and FIG 7B is a diagram illustrating the operation of the TMR element and its surroundings in the memory area.

FIG 8A is a diagram illustrating the operation of the TMR element and its surroundings in the memory area, FIG 8B is a diagram illustrating the operation of the TMR element and its surroundings in the memory area.

FIG. 9 is a diagram illustrating a manufacturing process of the structure of the TMR element and its surroundings.

FIG 10 is a diagram illustrating a manufacturing process of the structure of the TMR element and its surroundings.

FIG 11 is a diagram illustrating a manufacturing process of the structure of the TMR element and its surroundings.

FIG 12 is a diagram illustrating a manufacturing process of the structure of the TMR element and its surroundings.

FIG 13 is a diagram illustrating a manufacturing process of the structure of the TMR element and its surroundings.

FIG 14 is a diagram illustrating a manufacturing process of the structure of the TMR element and its surroundings.

FIG 15 is a diagram illustrating a manufacturing process of the structure of the TMR element and its surroundings.

FIG 16 is a diagram illustrating a manufacturing process of the structure of the TMR element and its surroundings.

FIG 17 is a diagram illustrating a manufacturing process of the structure of the TMR element and its surroundings.

FIG 18 is a diagram illustrating a manufacturing process of the structure of the TMR element and its surroundings.

FIG 19 is a diagram illustrating the shape of a magnetic yoke according to a modified example.

FIG. 20 is a diagram illustrating the shape of a magnetic yoke according to a modified example.

FIG 21A is a side cross-sectional view illustrating an exemplary structure of one memory area, and FIG 21B is a cross-sectional view of a TMR element structure, in the conventional MRAM.

### DESCRIPTION OF THE PREFERRED EMBODIMENTS

Hereafter, the preferred embodiments of the present invention will be described in detail referring to the drawings. In the description of the drawings, same numerals are given to the same elements, and duplication of the description is omitted.

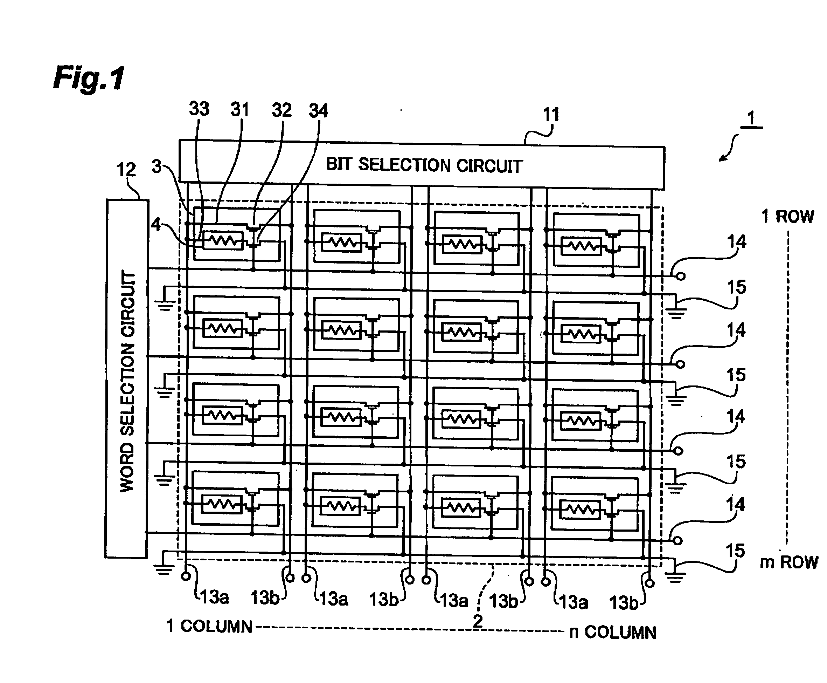

First, the structure of a magnetic memory according to one embodiment of the present invention is described hereafter. FIG 1 is a conceptual diagram of an overall structure of the magnetic memory according to the present embodiment. A magnetic memory 1 includes memory section 2, bit selection circuit 11, word selection circuit 12, bit wiring 13a, 13b, word wiring 14 and ground wiring 15. The memory section 2 includes a plurality of memory areas 3. A plurality of memory areas 3 are arranged in a two-dimensional form consisting of m rows and n columns (m, n are integers of 2 or more). Each of a plurality of memory areas 3 includes TMR element 4, write wiring 31, write transistor 32, readout wiring 33 and readout transistor 34.

The TMR element 4 is a magnetoresistive effect element including a magnetosensitive layer of which magnetization direction is changed by the external magnetic field. More specifically, the TMR element 4 includes a first magnetic layer, which is the magnetosensitive layer, a second magnetic layer having a fixed magnetization direction, and a nonmagnetic insulating layer being sandwiched between the first magnetic layer and the second magnetic layer. The TMR element 4 is disposed along a portion of the write wiring 31 so that the magnetization direction in the first magnetic layer is changed by receiving the external magnetic field produced by the write current flowing in the write wiring 31. When the magnetization direction in the first magnetic layer is changed by the write current, a resistance value between the first magnetic layer and the second magnetic layer is changed according to the relation between the magnetization direction in the first magnetic layer and the magnetization direction in the second magnetic layer.

The write wiring 31 is a kind of wiring to supply an external magnetic field to the first magnetic layer of the TMR element 4 by the write current. One end of the write wiring 31 is electrically connected to the bit wiring 13a. The other end of the write wiring 31 is electrically connected to the source or the drain of the write transistor 32. The write transistor 32 is a write switch means for controlling conduction of the write current in the write wiring 31. In the write transistor 32, either one of the drain and the source thereof is electrically connected to the write wiring 31, while the other is electrically connected to the bit wiring 13b. The gate of the write transistor 32 is electrically connected to the word wiring 14.

The readout wiring 33 is a kind of wiring to make a readout current flow into the TMR element 4. More specifically, one end of the readout wiring 33 is electrically connected to the bit wiring 13a, while the other end of the readout wiring 33 is electrically connected to the first magnetic layer side of the TMR element 4. Further, the readout transistor 34 is a readout switch means for controlling conduction of the readout current in the readout wiring 33. Either one of the source and the drain of the readout transistor 34 is electrically connected to the second magnetic layer side of the TMR element 4, while the other of the source and the drain is electrically connected to the ground wiring 15. Also, the gate of the readout transistor 34 is electrically connected to the word wiring 14. In the above description, the first magnetic layer side (or the second magnetic layer side) of the TMR element 4 signifies the side of the first magnetic layer (or the side of the second magnetic layer) against the nonmagnetic insulating layer, which includes a case of another layer intervening on the first magnetic layer (or the second magnetic layer).

Each bit wiring 13a, 13b is disposed correspondingly to each column of the memory areas 3. The bit wiring 13a is a first wiring in the present embodiment. Namely, the bit wiring 13a is electrically connected to one end of the write wiring 31 provided in each memory area 3 of the corresponding column. The bit wiring 13a in accordance with the present embodiment is also electrically connected to one end of the readout wiring 33 provided in each memory area 3 of the corresponding column. The bit wiring 13b is electrically connected to the drain or the source of the write transistor 32 provided in each memory area 3 of the corresponding column. Further, the word wiring 14 is a second wiring in the present embodiment. Namely, the word wiring 14 is disposed correspondingly to each row of the memory areas 3, and electrically connected to the gate, a control terminal, of the write transistor 32 provided in each memory area 3 of the corresponding row.

The bit selection circuit 11 is a write current generation means in the present embodiment. Namely, the bit selection circuit 11 has a function of supplying a positive or a negative write current to the write wiring 31 of each memory area 3. More specifically, the bit selection circuit 11 is constituted of an address decoder circuit for selecting a column corresponding to the address specified from the inside or the outside of the magnetic memory 1 at the time of data writing; and a current drive circuit for supplying the positive or the negative write current between the bit wiring 13a and the bit wiring 13b corresponding to the selected column. Also, the word selection circuit 12 has functions of selecting a row corresponding to the address specified from the inside or the outside of the magnetic memory 1 at the time of data writing, and supplying the word wiring 14 corresponding to the selected row with the control current.

The magnetic memory 1 having the above structure operates in the following way. When a data write address (i-row and j-column, 1 ≤ i ≤ m, 1 ≤ j ≤ n) is specified from the inside or the outside of the magnetic memory 1, the bit selection circuit 11 and the word selection circuit 12 select the corresponding j-column and i-row, respectively. In the write transistor 32 of the memory area 3 included in the i-row being selected by the word selection circuit 12, a control current is supplied to the gate, thereby producing a conductive state of the write current. Also, in the memory area 3 included in the j-column being selected by the bit selection circuit 11, a positive or a negative voltage according to the data is applied between the bit wiring 13a and the bit wiring 13b. Further, in the memory area 3 included in both the j-column being selected by the bit selection circuit 11 and the i- row being selected by the word selection circuit 12, a write current is produced in the write wiring 31 through the write transistor 32. Due to the magnetic field produced by the above write current, the magnetization direction in the first magnetic layer in the TMR element 4 is reversed. Thus, a binary data is stored into the memory area 3 of the specified address (i-row, j-column).

Also, when a data readout address (k-row and 1-column, 1 ≤ k ≤ m, 1 ≤ 1 ≤n) is specified from the inside or the outside of the magnetic memory 1, the bit selection circuit 11 and the word selection circuit 12 select the corresponding 1-column and k-row, respectively. In the readout transistor 34 of the memory area 3 included in the k-row being selected by the word selection circuit 12, a control current is supplied to the gate, thereby producing a conductive state of the readout current. Further, to the bit wiring 13a corresponding to the 1-column being selected by the bit selection circuit 11, a readout current is supplied from the bit selection circuit 11. Further, in the memory area 3 included in both the 1-column being selected by the bit selection circuit 11 and the k- row being selected by the word selection circuit 12, a readout current from the readout wiring 33 flows to the ground wiring 15 through the TMR element 4 and the readout transistor 34. Then, for example, by determining the amount of voltage drop in the TMR element 4, a binary data being stored in the specified address (k-row,1-column) is read out.

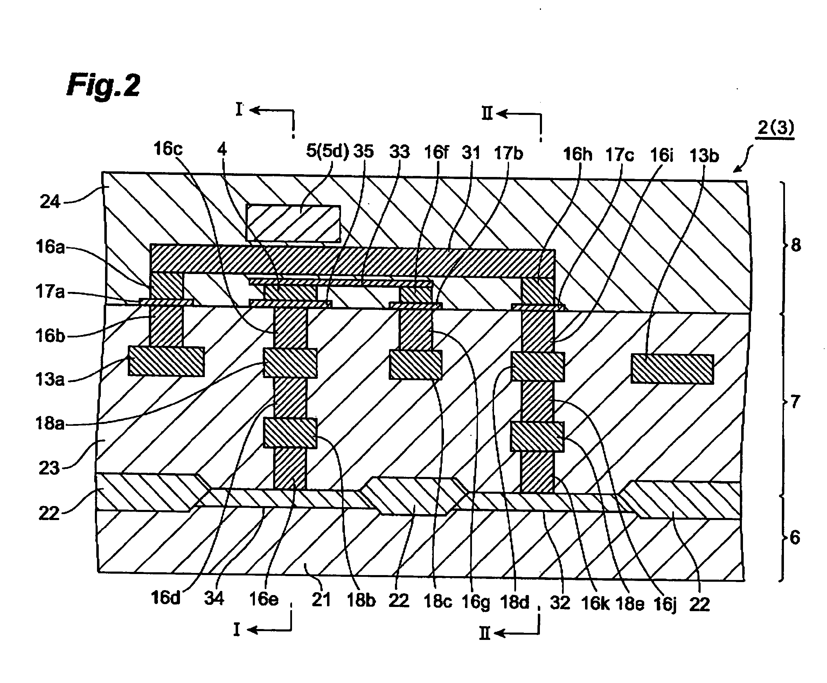

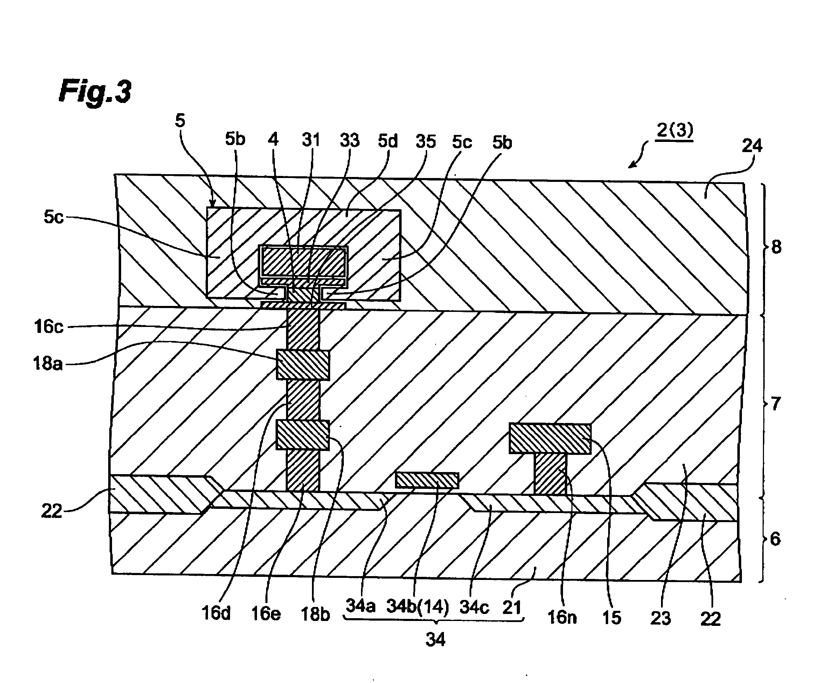

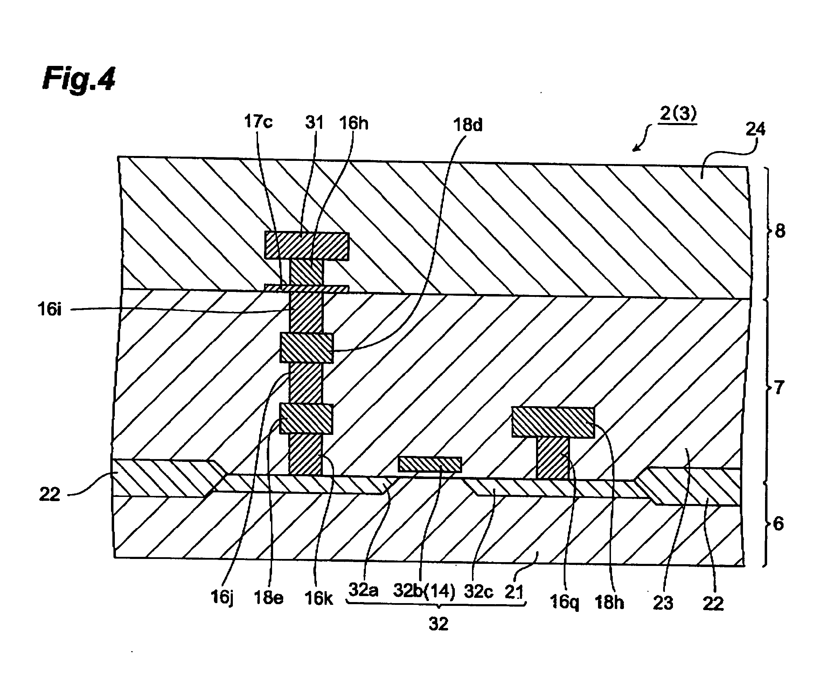

Now, a typical structure of the memory section 2 according to the present embodiment is described in detail. FIG. 2 is an enlarged cross-sectional view illustrating a cross-sectional structure when being cut along the row direction of the memory section 2. FIG 3 is an enlarged cross-sectional view of the memory section 2 when being cut along the line I - I shown in FIG 2. FIG. 4 is an enlarged cross-sectional view of the memory section 2 when being cut along the line II - II shown in FIG 2.

Referring to FIGS. 2 to 4, the memory section 2 includes a semiconductor layer 6, a wiring layer 7 and a magnetic material layer 8. The semiconductor layer 6 is a layer in which semiconductor devices such as transistors are formed, including a semiconductor substrate 21 so as to maintain the mechanical strength. The magnetic material layer 8 is a layer in which compositions of magnetic material such as the TMR element 4 and a magnetic yoke 5 for supplying a magnetic field to the TMR element 4 are formed. The wiring layer 7 is disposed between the semiconductor layer 6 and the magnetic material layer 8. The wiring layer 7 is a layer in which the wiring is formed so as to electrically connecting mutually among the magnetic devices including the TMR element 4 formed in the magnetic material layer 8, the semiconductor devices including transistors formed in the semiconductor layer 6, and the wiring penetrating each memory area 3 including the bit wiring 13a, 13b, and the word wiring 14.

First, the semiconductor layer 6 is described. The semiconductor layer 6 includes semiconductor substrate 21, insulating region 22, write transistor 32 and readout transistor 34. The semiconductor substrate 21 is formed of, for example, a Si substrate, having p-type or n-type impurities doped therein. The insulating region 22 is formed in regions except regions of the write transistor 32 and the readout transistor 34 of the semiconductor substrate 21, so as to electrically isolate the write transistor 32 from the readout transistor 34. The insulating region 22 is formed of an insulating material such as SiO₂.

Referring to FIG. 3, the readout transistor 34 is constituted of a drain region 34a and a source region 34c of opposite conductivity type to the semiconductor substrate 21; a gate electrode 34b; and a portion of the semiconductor substrate 21. The drain region 34a and the source region 34c are formed with impurities of opposite conductivity type to the semiconductor substrate 21 being doped in the vicinity of the surface of, for example, the Si substrate. The semiconductor substrate 21 intervenes between the drain region 34a and the source region 34c, and the gate electrode 34b is disposed on the semiconductor substrate 21. With such a structure, in the readout transistor 34, the drain region 34a and the source region 34c are mutually conductive when a voltage is applied to the gate electrode 34b.

Referring to FIG 4, the write transistor 32 is constituted of a drain region 32a and a source region 32c of opposite conductivity type to the semiconductor substrate 21, a gate electrode 32b, and a portion of the semiconductor substrate 21. The drain region 32a and the source region 32c are formed with doped impurities of opposite conductivity type to the semiconductor substrate 21, for example, in the vicinity of the Si substrate surface. The semiconductor substrate 21 intervenes between the drain region 32a and the source region 32c, and the gate electrode 32b is disposed on the semiconductor substrate 21. With such a structure, in the write transistor 32, the drain region 32a and the source region 32c are mutually conductive when a current is applied to the gate electrode 32b.

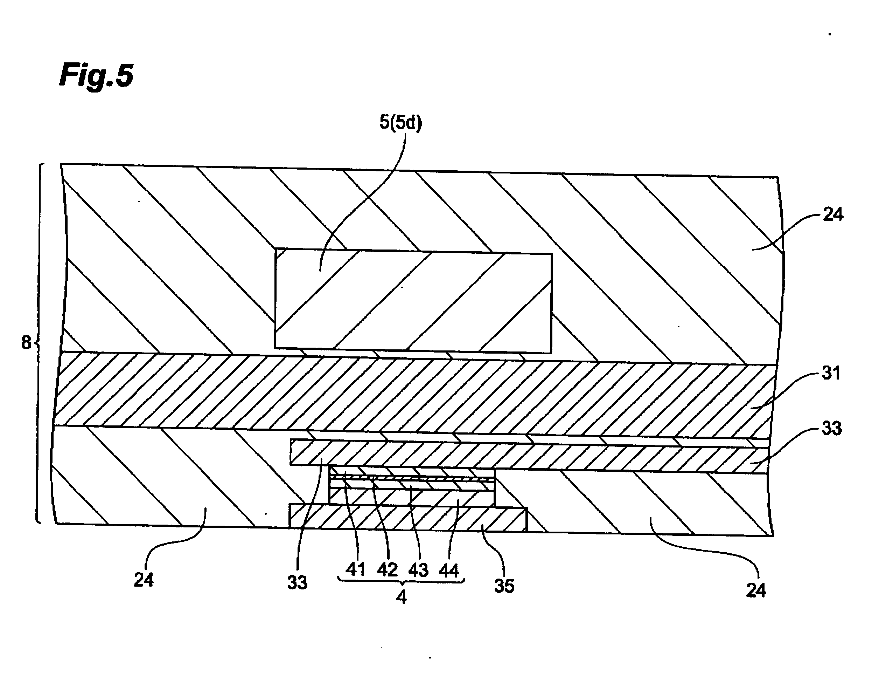

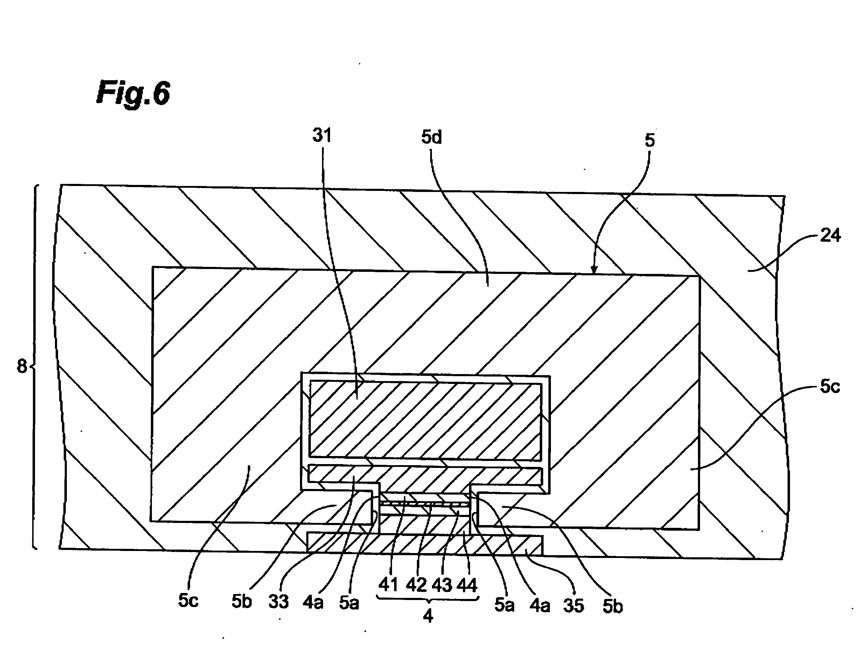

Next, the magnetic material layer 8 is described hereafter. The magnetic material layer 8 includes TMR element 4, magnetic yoke 5, insulating region 24, write wiring 31 and readout wiring 33. The region excluding the components described below (TMR element 4, magnetic yoke 5, write wiring 31 and readout wiring 33), and also excluding other wiring, is occupied by the insulating region 24. Here, FIGS. 5 and 6 are enlarged diagrams of the TMR element 4 and the surrounding structure thereof. FIG 5 shows a cross section of the memory area 3 along the row direction, while FIG 6 shows a cross section of the memory area 3 along the column direction. Referring to FIGS. 5 and 6, the TMR element 4 is formed of first magnetic layer 41, nonmagnetic insulating layer 42, second magnetic layer 43 and antiferromagnetic layer 44 that are laminated successively. The first magnetic layer 41 is a magnetosensitive layer in the present embodiment, of which magnetization direction is changed by the external magnetic field from the write wiring 31, thus enabling recording of binary data. As material of the first magnetic layer 41, ferromagnetic materials including, for example, Co, CoFe, NiFe, NiFeCo and CoPt may be used.

Meanwhile, in the second magnetic layer 43, the magnetization direction is fixed by the antiferromagnetic layer 44. Namely, by the exchanging coupling at a junction plane between the antiferromagnetic layer 44 and the second magnetic layer 43, the magnetization direction in the second magnetic layer 43 is stabilized. The easy-to-magnetize axis direction of the second magnetic layer 43 is set so as to run along the easy-to-magnetize axis direction of the first magnetic layer 41. As a material of the second magnetic layer 43, a ferromagnetic material including, for example, Co, CoFe, NiFe, NiFeCo and CoPt may be used. Also, as material of the antiferromagnetic layer 44, materials including IrMn, PtMn, FeMn, PtPdMn and NiO, or an arbitrary combination thereof may be used.

The nonmagnetic insulating layer 42 is a layer formed of a material that is nonmagnetic and insulating. By means of the nonmagnetic insulating layer 42 intervening between the first magnetic layer 41 and the second magnetic layer 43, the tunneling magnetoresistive (TMR) effect is produced between the first magnetic layer 41 and the second magnetic layer 43. Namely, between the first magnetic layer 41 and the second magnetic layer 43, there is produced an electric resistance depending on relative relation (parallel or antiparallel) between the magnetization direction in the first magnetic layer 41 and the magnetization direction in the second magnetic layer 43. As material of the nonmagnetic insulating layer 42, for example, oxide or nitride of metal including, for example, Al, Zn and Mg is preferable.

As the layer for stabilizing the magnetization direction in the second magnetic layer 43, in place of the antiferromagnetic layer 44, it may also be possible to provide a third magnetic layer, with a nonmagnetic metal layer or a synthetic antiferromagnetic (AF) layer intervening between the second and the third magnetic layers. By forming antiferromagnetic coupling with the second magnetic layer 43, the third magnetic layer can further stabilize the magnetization direction in the second magnetic layer 43. Also, because the effect of a static magnetic field from the second magnetic layer 43 to the first magnetic layer 41 can be prevented, it becomes possible to make magnetization reversal of the first magnetic layer 41 easy. As material of such the third magnetic layer, although there is no particular restriction, it is preferable to use a ferromagnetic material such as Co, CoFe, NiFe, NiFeCo and CoPt alone or in a compound form. Further, as material of the nonmagnetic metallic layer disposed between the second magnetic layer 43 and the third magnetic layer, Ru, Rh, Ir, Cu and Ag are preferable. Additionally, as the thickness of the nonmagnetic metallic layer, it is preferable to be 2 nm or less, so as to obtain strong antiferromagnetic coupling between the second magnetic layer 43 and the third magnetic layer.

On the first magnetic layer 41 of the TMR element 4, the readout wiring 33 is provided. The readout wiring 33 is formed of a conductive metal that extends to the row direction of the memory area 3. One end of the readout wiring 33 is electrically connected to the first magnetic layer 41. The other end of the readout wiring 33 is electrically connected to an electrode 17b by means of a vertical wiring 16f (refer to FIG 2). Also, the antiferromagnetic layer 44 of the TMR element 4 is provided on an electrode 35, and is electrically connected to the electrode 35. With the above structure, the readout current can be made to flow from the readout wiring 33 to the TMR element 4.

Further, the write wiring 31 is disposed on the readout wiring 33. A gap is provided between the readout wiring 33 and the write wiring 31, and insulation is made therebetween by means of filling with material of the insulating region 24. The write wiring 31 is formed of a conductive metal, which extends to the row direction of the memory area 3. One end of the write wiring 31 is electrically connected to an electrode 17a by means of a vertical wiring 16a (refer to FIG 2). Also, the other end of the write wiring 31 is electrically connected to an electrode 17c by means of a vertical wiring 16h (refer to FIG 2). Additionally, the easy-to-magnetize axis direction of the first magnetic layer 41 in TMR element 4 is set so as to run along a direction intersecting the longitudinal direction of the write wiring 31 (i.e. a direction intersecting the write current direction).

The magnetic yoke 5 is a ferromagnetic member overlaying the periphery of the write wiring 31, for efficiently supplying the TMR element 4 with the magnetic field produced by the write current. The magnetic yoke 5 is formed of an approximate ring shape, having at least a pair of open end portions disposed face-to-face with a gap of a predetermined length intervening therebetween, and disposed so as to surround the periphery of the write wiring 31 at a portion of the write wiring in the extending direction 31. More specifically, the magnetic yoke 5 is structured of a pair of face-to-face yokes 5b, a pair of pillar yokes 5c and a beam yoke 5d. Here, the pair of face-to-face yokes 5b has a pair of end faces 5a, as a pair of open end portions. The above pair of end faces 5a is disposed face-to-face along the easy-to-magnetize axis direction of the first magnetic layer 41, with a gap of a predetermined length intervening therebetween. Further, the TMR element 4 is disposed in such a way that a pair of side faces 4a (refer to FIG 6) of the TMR element 4 lies face-to-face to the pair of end faces 5a, and that the easy-to-magnetize axis direction in the first magnetic layer 41 runs along the arranged direction of the pair of end faces 5a. Also, the beam yoke 5d is disposed along a face of the write wiring 31 opposite to the TMR element 4 side. Along the side faces of the write wiring 31, the pair of pillar yokes 5c is disposed, so as to connect the both ends of the beam yoke 5d to the ends of the pair of face-to-face yokes 5b respectively positioned on the different sides from the end faces 5a. With the above structure, the face-to-face yokes 5b, the pillar yokes 5c and the beam yoke 5d surround the periphery of the write wiring 31 at a portion of the write wiring 31 in its extending direction.(a portion on the TMR element 4).

As material constituting the magnetic yoke 5, preferably, a metal including at least one element among, for example, Ni, Fe and Co may be used. Further, the magnetic yoke 5 is formed so that the easy-to-magnetize axis direction thereof runs along the easy-to-magnetize axis direction of the first magnetic layer 41 in the TMR element 4. Also, the cross section area of the magnetic yoke 5 at the plane perpendicular to the surrounding direction of the write wiring 31 is set to be the smallest at the pair of end faces 5a. More specifically, among the face-to-face yoke 5b, the pillar yoke 5c and the beam yoke 5d of the magnetic yoke 5, the cross section area of the face-to-face yoke 5b is set to be the smallest. Further, preferably, the face-o-face yoke 5b is structured to be thinner in a nearer position to the end face 5a.

As material of the insulating region 24, similar to the insulating layer 22 of the semiconductor layer 6, an insulating material such as SiO₂ may be used.

Next, the wiring layer 7 is described. The wiring layer 7 includes insulating layer 23, bit wiring 13a, 13b, word wiring 14, ground wiring 15, and also a plurality of vertical wirings and horizontal wirings. Additionally, in regard to the wiring layer 7, the entire region excluding each wiring is occupied by the insulating region 23. As material of the insulating region 23, similar to the insulating region 22 in the semiconductor layer 6, insulating material such as SiO₂ may be used. Also, as material of the vertical wiring, for example, W, and as material of the horizontal wiring, for example, Al may be used, respectively.

Referring to FIG 2, the electrode 17a, which is connected to one end of the write wiring 31 of the magnetic material layer 8, is electrically connected to the bit wiring 13a by means of the vertical wiring 16b. Also, the electrode 35, which is electrically connected to the second magnetic layer 43 side of the TMR element 4 is electrically connected to vertical wirings 16c - 16e and horizontal wirings 18a, 18b of the wiring layer 7, and a vertical wiring 16e has ohmic contact with the drain region 34a of the readout transistor 34 (refer to FIG. 3). Further, the electrode 17b, which is electrically connected to the first magnetic layer 41 side of the TMR element 4 in the magnetic material layer 8 through the readout wiring 33, is also electrically connected to a horizontal wiring 18c by means of a vertical wiring 16g. In addition, a horizontal wiring 18c is electrically connected to the bit wiring 13a by means of a non-illustrated wiring.

Further, referring to FIG 3, the ground wiring 15 is electrically connected to a vertical wiring 16n, and the vertical wiring 16n has ohmic contact with the source region 34c of the readout transistor 34. Also, a portion of the word wiring 14 becomes a gate electrode 34b of the readout transistor 34. Namely, the gate electrode 34b shown in FIG 3 is constituted of a portion of the word wiring 14 extending to the row direction of the memory area 3. With such a structure, the word wiring 14 is electrically connected to the control terminal (gate electrode 34b) of the readout transistor 34.

Further, referring to FIG. 4, the electrode 17c, which is connected to the other end of the write wiring 31 of the magnetic material layer 8, is electrically connected to vertical wirings 16i - 16k and horizontal wirings 18d, 18e in the wiring layer 7. The vertical wiring 16k has ohmic contact with the drain region 32a of the write transistor 32. Also, the horizontal wiring 18h is electrically connected to a vertical wiring 16q, and the vertical wiring 16q has ohmic contact with the source region 32c of the write transistor 32. Additionally, the horizontal wiring 18h is electrically connected to the bit wiring 13b (refer to FIG 2) by means of non-illustrated wiring. Also, a portion of the word wiring 14 becomes the gate electrode 32b of the write transistor 32. Namely, the gate electrode 32b shown in FIG. 4 is constituted of a portion of the word wiring 14 extending to the row direction of the memory area 3. With such a structure, the word wiring 14 is electrically connected to the control terminal (gate electrode 32b) of the write transistor 32.

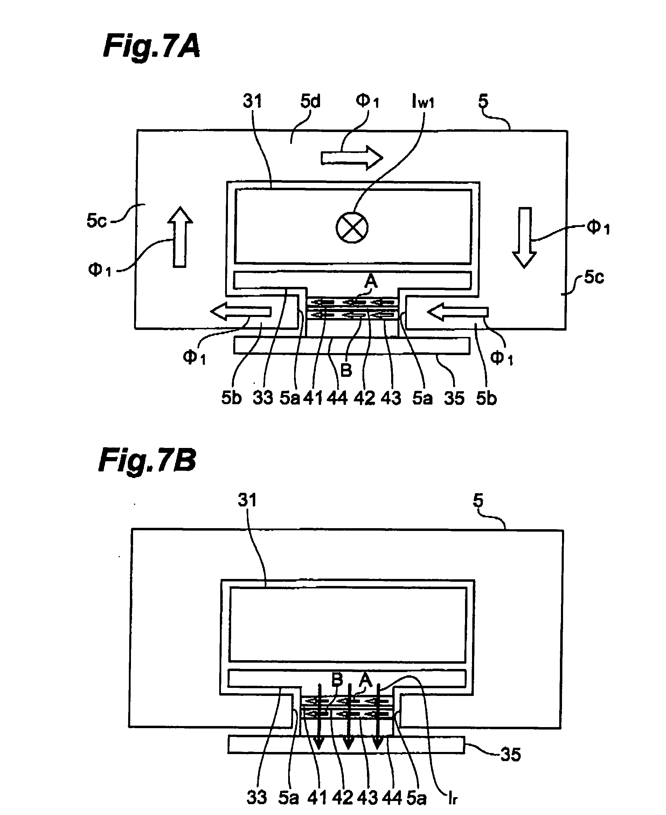

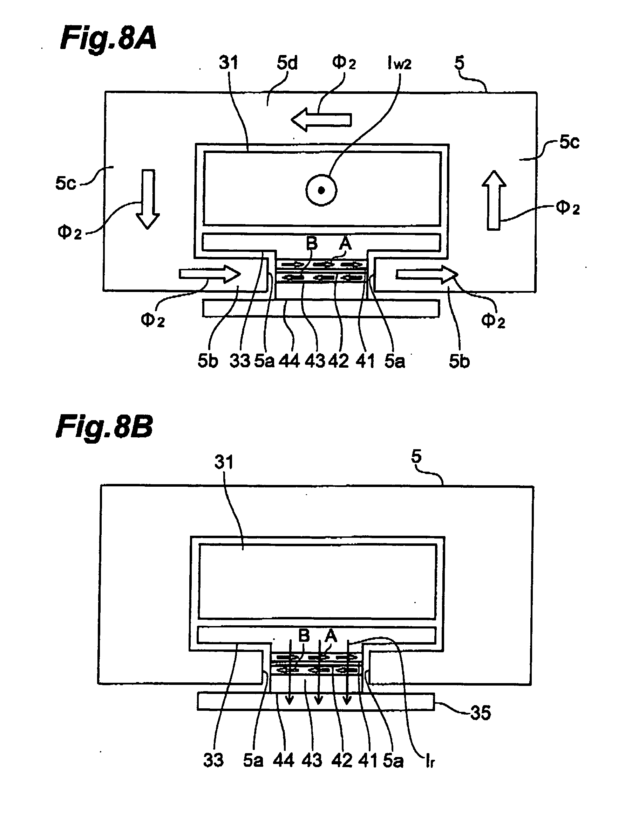

Now, referring to FIGS. 7 and 8, the operation of the TMR element 4 and its surrounding in the memory area 3 of the present embodiment is described. As shown in FIG 7A, when a negative current I_{w1} flows in the write wiring 31, a magnetic field Φ₁ is produced in the surrounding direction of the write wiring 31, in the periphery of the write wiring 31. The magnetic field Φ₁ forms a closed path through the inside of the magnetic yoke 5 disposed in the periphery of the write wiring 31, and the gap between the pair of end faces 5a. Here, according to the present embodiment, among the face-to-face yoke 5b, the pillar yoke 5c and the beam yoke 5d of the magnetic yoke 5, the cross section area of the face-to-face yoke 5b is the smallest. Therefore, the magnetic flux density of the magnetic field Φ₁ being formed inside the magnetic yoke 5 becomes the greatest in the face-to-face yoke 5b.

On the occurrence of the magnetic field Φ₁ produced in the periphery of the write wiring 31, because of the function of the magnetic field confinement in the magnetic yoke 5, the magnetic field Φ₁ (external magnetic field) can be supplied efficiently to the first magnetic layer 41 of the TMR element 4. Caused by the above magnetic field Φ₁, the magnetization direction A in the first magnetic layer 41 is oriented in the same direction as the direction of the magnetic field Φ₁. Here, in case that the magnetization direction B of the second magnetic layer 43 is oriented in the same direction as the magnetic field Φ₁ in advance through the exchange coupling with the antiferromagnetic layer 44, the magnetization direction A of the first magnetic layer 41 and the magnetization direction B of the second magnetic layer 43 is oriented mutually in the same direction, that is, falls into a parallel state. Thus, one (for example, 0) of the binary data is written in the TMR element 4.

When reading out the binary data stored in the TMR element 4, as shown in FIG 7B, a readout current Iᵣ is made to flow between the readout wiring 33 and the electrode 35, so as to detect a change of the current value or a change of the potential difference between the readout wiring 33 and the electrode 35. With this, it becomes possible to decide which of the binary data is recorded in the TMR element 4 (namely, whether the magnetization direction A of the first magnetic layer 41 is parallel or antiparallel to the magnetization direction B of the second magnetic layer 43). For example, when the magnetization direction A of the first magnetic layer 41 is parallel to the magnetization direction B of the second magnetic layer 43, due to the tunneling magnetoresistive (TMR) effect in the nonmagnetic insulating layer 42, the resistance value between the first magnetic layer 41 and the second magnetic layer 43 becomes relatively small. Therefore, for example, when the readout current Iᵣ is constant, the potential difference between the readout wiring 33 and the electrode 35 becomes relatively small, and it is found out that, as binary data, 0 is stored in the TMR element 4.

Also, as shown in FIG 8A, when a positive current I_{w2} flows in the write wiring 31, a magnetic field Φ₂ rotating in the opposite direction to the magnetic field Φ₁ is produced in the periphery of the write wiring 31. The magnetic field Φ₂ forms a closed path through the inside of the magnetic yoke 5 and the gap between the pair of end faces 5a. Here, similar to the magnetic field Φ₁, the magnetic flux density of the magnetic field Φ₂ formed inside the magnetic yoke 5 becomes the greatest in the face-to-face yoke 5b.

On the occurrence of the magnetic field Φ₂ in the periphery of the write wiring 31, because of the function of the magnetic field confinement in the magnetic yoke 5, the magnetic field Φ₂ (external magnetic field) can be supplied efficiently to the first magnetic layer 41 of the TMR element 4. Caused by the above magnetic field Φ₂, the magnetization direction A in the first magnetic layer 41 is oriented in the same direction as the direction of the magnetic field Φ₂. Here, in case that the magnetization direction B of the second magnetic layer 43 is oriented in the opposite direction to the magnetic field Φ₂, the magnetization direction A of the first magnetic layer 41 and the magnetization direction B of the second magnetic layer 43 is oriented mutually in the opposite direction, that is, in an antiparallel state. Thus, the other binary data (for example, 1) is written in the TMR element 4.

For example, when the magnetization direction A of the first magnetic layer 41 is antiparallel to the magnetization direction B of the second magnetic layer 43, due to the tunneling magnetoresistive (TMR) effect in the nonmagnetic insulating layer 42, the resistance value between the first magnetic layer 41 and the second magnetic layer 43 becomes relatively large. Accordingly, as exemplarily shown in FIG 8B, when a certain readout current Iᵣ is made to flow between the readout wiring 33 and the electrode 35, the potential difference between the readout wiring 33 and the electrode 35 becomes relatively large. With this, it is found out that, as binary data, 1 is stored in the TMR element 4.

The effects of the magnetic memory 1 according to the present embodiment having been described above will be described. In the magnetic memory 1 according to the present embodiment, the magnetic yoke 5 is formed of an approximate ring shape, which is disposed in such a way as to surround the periphery of the write wiring 31 at a portion of the write wiring 31 in its extending direction. Because the write wiring 31 is surrounded by the magnetic yoke 5, the magnetic field going out to the direction deflected from the TMR element 4 can be reduced. Also, because the magnetic yoke 5 has a pair of end faces 5a respectively disposed face-to-face to a pair of side faces 4a of the TMR element 4, it is possible to efficiently supply the first magnetic layer 41 of the TMR element 4 with the magnetic fields Φ₁, Φ₂ which are produced inside the magnetic yoke 5 constituting a closed path in the direction of the periphery of the write wiring 31. As such, in the magnetic memory 1 according to the present embodiment, the magnetic fields Φ₁, Φ₂ caused by the write currents I_{w1}, I_{w2} can be supplied to the first magnetic layer 41 of the TMR element 4 efficiently. Accordingly, it is possible to reverse the magnetization direction A of the first magnetic layer 41 in the TMR element 4 by means of small write currents I_{w1}, I_{w2}.

Further, according to the magnetic memory 1 of the present embodiment, because the magnetization direction A of the first magnetic layer 41 can be reversed by small write currents I_{w1,} I_{w2,} the write transistor 32 for controlling the conduction of the write currents I_{w1}, I_{w2} may be miniaturized, which enables the write transistor 32 to be disposed for each memory area 3. Accordingly, it is virtually possible to supply the magnetic fields Φ₁, Φ₂ only to the TMR element 4 in the memory area 3 to which the data is to be written, and incorrect writing to other memory areas 3 can be prevented.

Also, in the conventional magnetic memory, as shown in FIGS. 21A and 21B, a synthetic magnetic field produced by mutually intersecting two wirings 102, 104 has been used. Therefore, in order that the magnetization direction in the magnetosensitive layer is not reversed by the magnetic field produced by a single wiring 102 or 104, and that the magnetization direction in the magnetosensitive layer is reversed without fail by the synthetic magnetic field produced by the two wirings, it has been required to realize the amount of the write current and the magnetization characteristic of the magnetosensitive layer (such as the amount of magnetic field when the magnetization direction is reversed). However, it is not easy to produce the magnetic memory capable of accurately performing write operation in a multiplicity of memory areas, because the magnetization characteristic of the magnetosensitive layer deviates due to a temperature change, magnetic noise, etc. In contrast, according to the magnetic memory 1 of the present embodiment, because the write transistor 32 can be provided for each memory area 3, only the magnetic fields Φ₁, Φ₂ from the write wiring 31 are to be supplied to each TMR element 4. The use of the synthetic magnetic field becomes unnecessary. The magnetic fields Φ₁, Φ₂ may only have such intensity as being sufficient for reversing the magnetization direction A of the first magnetic layer 41. Thus, data can be securely written into the TMR element 4, even when the magnetization characteristic of the magnetosensitive layer deviates to a certain extent due to a temperature change, magnetic noise, etc.

As shown in the present embodiment, preferably, a plurality of memory areas 3 is two-dimensionally arranged consisting of m rows and n columns (m, n are integers of 2 or more). In this case, preferably, the bit wring 13a disposed correspondingly to each column of a plurality of memory areas 3 is connected to one end of the write wiring 31 provided in each memory area 3 of the corresponding column. Also, in this case, the word wiring 14 disposed correspondingly to each row of a plurality of memory areas 3 is connected to the gate electrode 32b of the write transistor 32 provided in each memory area 3 of the corresponding row. With this, the memory area 3 to which data is to be written can be selected with a simple structure and operation.

Further, as shown in the present embodiment, preferably, the magnetic memory 1 includes a bit selection circuit 11 as a write current generation means for supplying a positive write current I_{w2} and a negative write current I_{w1} to the write wiring 31. In this magnetic memory 1, the bit selection circuit 11 supplies the write wiring 31 with either one of the positive write current I_{w2} or the negative write current I_{w1}, depending on the need. Thus, the magnetization direction A in the first magnetic layer 41 of the TMR element 4 can be reversed appropriately.

Still further, as shown in the present embodiment, preferably, the easy-to-magnetize axis direction in the magnetic yoke 5 runs along the easy-to-magnetize axis direction in the first magnetic layer 41. Also, preferably, the cross section area of the magnetic yoke 5 perpendicular to the surrounding direction is the smallest at the pair of end faces 5a. With the above structure, it is possible to supply the magnetic fields Φ₁, Φ₂ inside the magnetic yoke 5 to the first magnetic layer 41 of the TMR element 4 more efficiently.

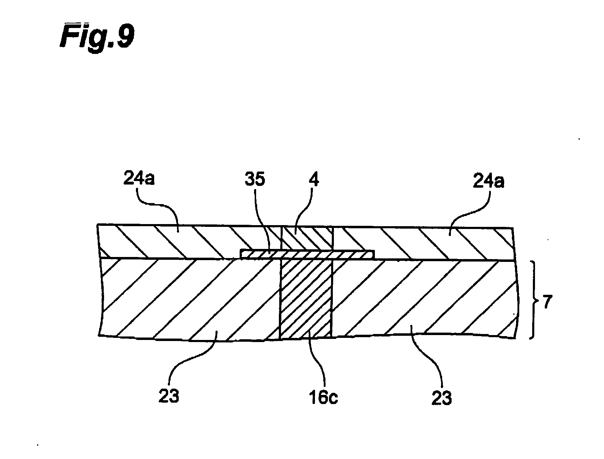

Now, among manufacturing methods of the magnetic memory 1 according to the present embodiment, a manufacturing method of the structure of the TMR element 4 and its surroundings is described referring to FIGS. 9 through 18. Here, FIGS. 9 through 18 respectively show the cross section cut along the line I - I shown in FIG 2, and the manufacturing process therefor is illustrated in sequence.

First, a semiconductor layer 6 and a wiring layer 7 (refer to FIG 2) are formed. As shown in FIG 9, after an electrode 35 is formed on a vertical wiring 16c of a wiring layer 7, in order to form a TMR element 4, for example, Ta underlayer, IrMn layer, CoFe layer and Al layer are film formed successively using ultra-high vacuum (UHV) DC sputtering equipment. Thereafter, the Al layer is oxidized through oxygen Plasma, and after a tunneling insulating layer (that is, a layer which is to become the nonmagnetic insulating layer shown in FIGS. 5 and 6) is formed, the CoFe layer and the Ta protection layer are formed.

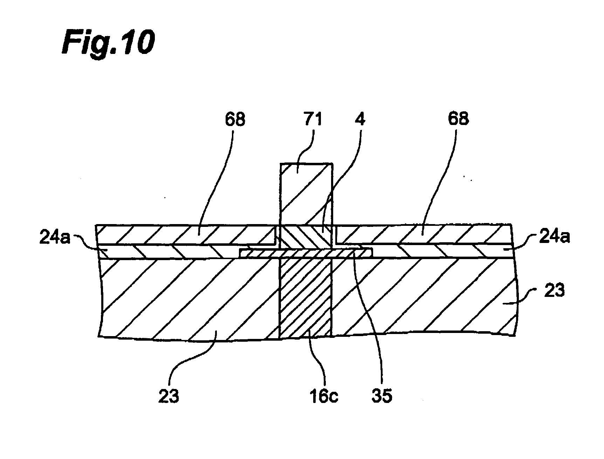

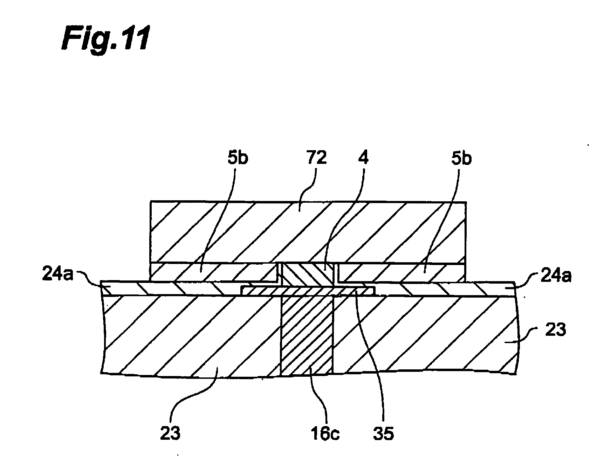

Next, as shown in FIG 10, after forming a resist mask 71 using lithography equipment, the TMR element 4 is formed through the ion milling. Thereafter, by use of chemical vapor deposition (CVD) equipment, a SiO₂ insulating layer 24a is formed on the side faces of the TMR element 4 and in the upper portion of the electrode 35, using for example, Si(OC₂H₅)₄. Further, in order to form a pair of face-to-face yokes 5b, for example, a NeFe film 68 is formed using sputtering equipment, and then the resist mask 71 is removed. Then, as shown in FIG 11, a resist mask 72 corresponding to the shape of the face-to-face yoke 5b is formed on both the NiFe film 68 and the TMR element 4. By forming the NiFe film 68 through the ion milling, the pair of face-to-face yokes 5b is formed. Thereafter, the resist mask 72 is removed.

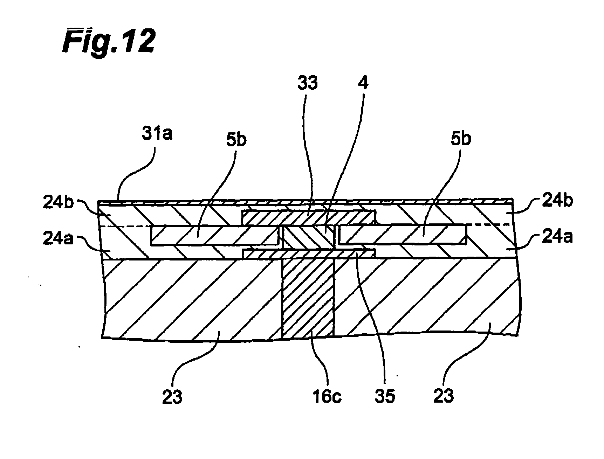

Subsequently, as shows in FIG 12, a readout wiring 33 is formed so as to contact with the upper face of the TMR element 4. Next, an insulating layer 24b constituted of the same material as the insulating layer 24a is formed on the readout wiring 33, on the insulating layer 24a and on the face-to-face yokes 5b, using the CVD method. Then, a plating underlay film 31a, constituted of material having high conductivity such as Cu, is formed on the insulating layer 24b through sputtering.

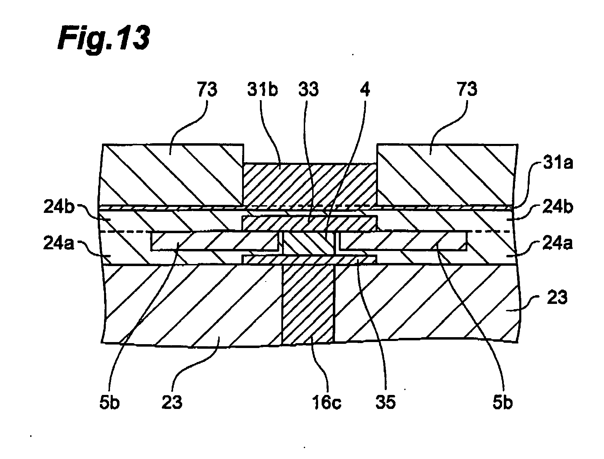

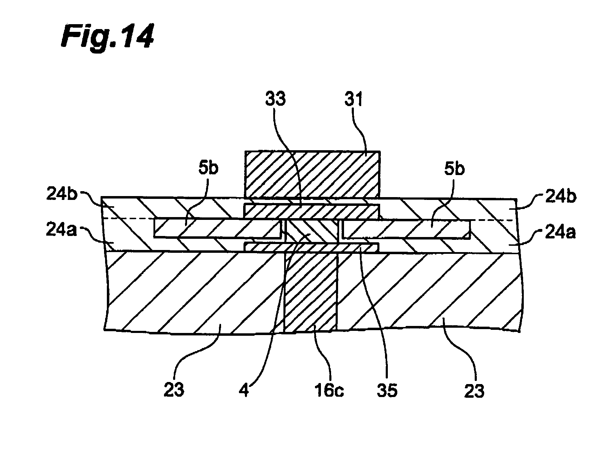

Subsequently, as shown in FIG 13, a resist mask 73 is formed selectively on the plating underlayer film 31a. Here, a resist mask 73 is formed on the TMR element 4, so that the resist mask 73 has an aperture in a region larger than the upper face of the TMR element 4. Thereafter, the whole composition is dipped in a plating tank, and write wiring 31b is formed through plating processing, using the plating underlayfilm 31a as an electrode. After the plating processing, as shown in FIG 14, the resist mask 73 is removed, and also an exposed portion out of the plating underlayer film 31 a is removed through milling, etc. Thus, the write wiring 31 is formed.

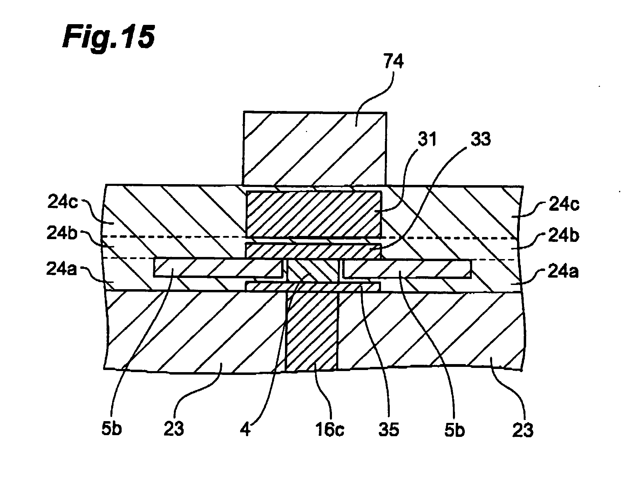

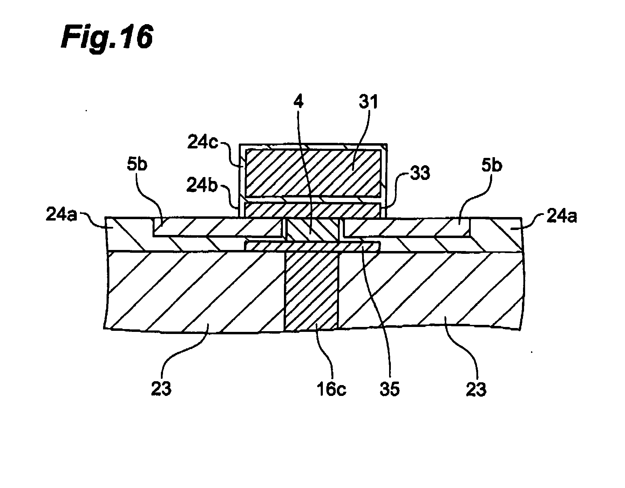

Subsequently, as shown in FIG 15, an insulating layer 24c constituted of the same material as the insulating layers 24a, 24b is formed on the write wiring 31 and the insulating layer 24b, using the CVD method. A resist mask 74 is then formed selectively on the insulating layer 24c. Here, on the write wiring 31, the resist mask 74 is formed on a region substantially larger than the upper face of the write wiring 31. Thereafter, portions of the insulating layers 24b, 24c which are not overlaid by the resist mask 74 are removed through RIE (reactive inn etching) or the like, so that the face-to-face yoke 5b is exposed, and then the resist mask 74 is removed (refer to FIG. 16).

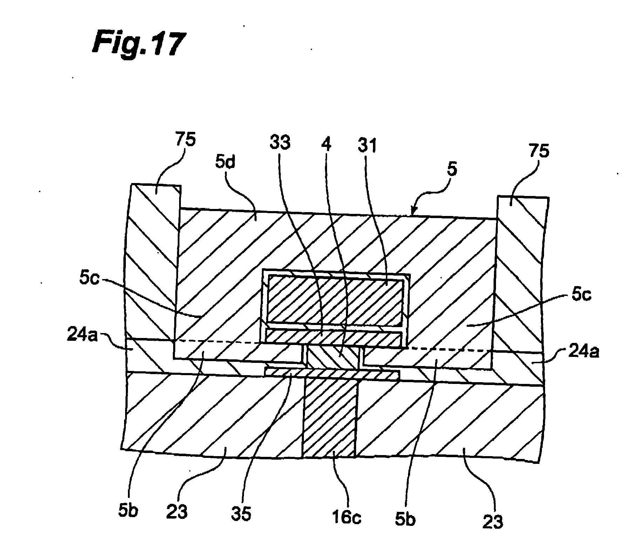

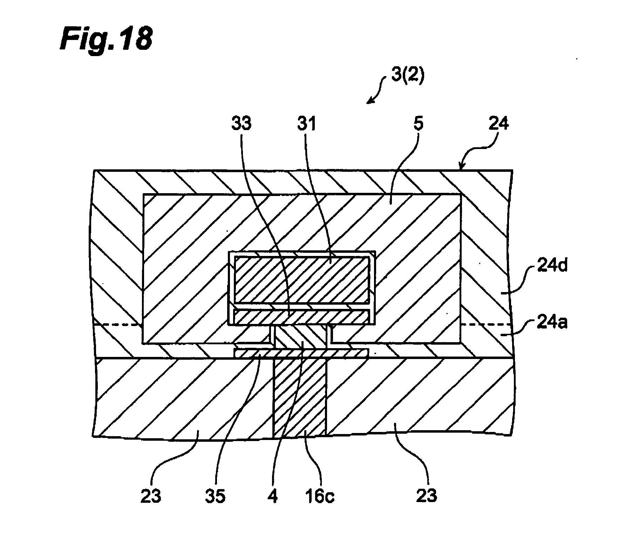

Subsequently, as shown in FIG. 17, a resist mask 75 is selectively formed on the insulating layer 24a. At this time, the resist mask 75 is formed so as not to overlay the face-to-face yokes 5b and the write wiring 31. Then, on a region in which the resist mask 75 is not provided, a pair of pillar yokes 5c and a beam yoke 5d is formed through, for example, sputtering. As a result, a magnetic yoke 5, including the pair of face-to-face yokes 5b, the pair of pillar yokes 5c and the beam yoke 5d, is formed. Lastly, as shown in FIG 18, the resist mask 75 is removed, and an insulating layer 24d constituted of the same material as the insulating layer 24a is formed on the insulating layer 24a and the magnetic yoke 5, using the CVD method. Thus, the insulating region 24 is formed, and the memory area 3 (memory section 2) is completed.

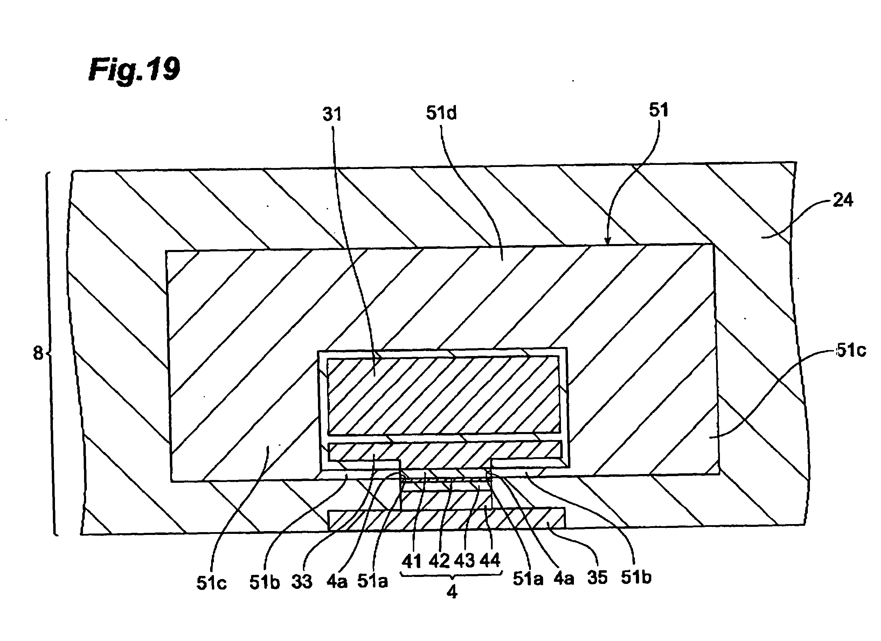

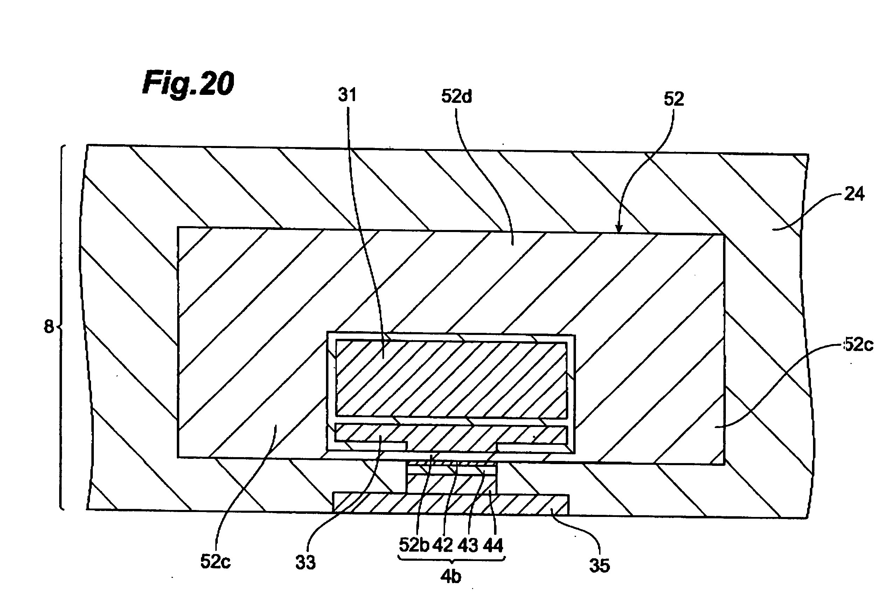

(Modified example) Hereafter, an example of modification of the magnetic memory 1 according to the present embodiment will be described. FIGS. 19, 20 respectively show cross-sectional views, illustrating shapes of the magnetic yokes 51, 52 according to the present modification example. In place of the magnetic yoke 5 in the embodiment described earlier, by providing the magnetic yokes 51, 52 of the present modification example, it is possible to obtain an effect to the same extent, or more, of the magnetic memory 1 according to the embodiment described before.

First, referring to FIG. 19, the magnetic yoke 51 includes a pair of face-to-face yokes 51b, a pair of pillar yokes 51c, and a beam yoke 51d. Among the above yokes, structures and shapes of the pair of the pillar yokes 51 c and the beam yoke 51d are the same as the structures and the shapes of the pair of the pillar yokes 5c and the beam yoke 5d described earlier (refer to FIG. 6). As to the pair of face-to-face yokes 51b, the end faces 51a thereof contact with the side faces of the first magnetic layer 41 among the side faces 4a of the TMR element 4. The magnetic yoke 51 may also be such the structure, making it possible to supply the first magnetic layer 51 with a magnetic field produced inside the magnetic yoke 51 by a write current more efficiently. Additionally, in this modification example, when the magnetic yoke 51 has electrical conductivity, in order to make a readout current flowing between the first magnetic layer 41 and the second magnetic layer 43 appropriately through the nonmagnetic insulating layer 42, preferably the pair of end faces 51a of the magnetic yoke 51 does not contact with the nonmagnetic insulating layer 42. The pair of end faces 51 a must not contact with the second magnetic layer 43.

Also, referring to FIG. 20, the magnetic yoke 52 includes a first beam yoke 52b, a pair of pillar yoke 52c, and a second beam yoke 52d. Among the above yokes, a first beam yoke 52b is disposed between a readout wiring 33 and a nonmagnetic insulating layer 42, so as to function as the first magnetic layer of a TMR element 4b also. Further, one end of the first beam yoke 52b is connected to one of the pair of pillar yokes 52c, while the other end of the first beam yoke 52b is connected to the other of the pair of pillar yokes 52c. Also, the beam yoke 52d is disposed along the face of the write wiring 31 on the opposite side to the TMR element 4. The pair of pillar yokes 52c is disposed along the side faces of the write wiring 31, connecting the both ends of the first beam yoke 52b to the both ends of the second beam yoke 52d. With the above-mentioned structure, the first beam yoke 52b, the pair of pillar yokes 52c and the second beam yoke 52d entirely (continuously) surround the periphery of the write wiring 51 at a portion of the write wiring 31 in its extending direction (a portion located on the TMR element 4). Also, the first magnetic layer of the TMR element 4b is constituted of a portion (the first beam yoke 52b) of the magnetic yoke 52. Accordingly, it becomes possible to supply the first magnetic layer of the TMR element 4b with the magnetic field produced inside the magnetic yoke 52 by the write current more efficiently.

The magnetic memory according to the present invention is not limited to the embodiments described above. A variety of other modifications is possible. For example, in the above description of the embodiments, the TMR element is employed as magnetoresistive effect element. However, it is possible to employ a GMR element in which giant magnetoresistive (GMR) effect is utilized. The GMR effect is a phenomenon such that, depending on an angle of magnetization direction of two ferromagnetic layers sandwiching a nonmagnetic layer, the resistance values of the ferromagnetic layers in the direction perpendicular to the lamination direction vary. Namely, in the GMR element, the resistance value of the ferromagnetic layer becomes the smallest when the magnetization directions of two ferromagnetic layers are mutually parallel, while the resistance value of the ferromagnetic layer becomes the largest when the magnetization directions of two ferromagnetic layers are mutually antiparallel. Additionally, in the TMR element and the GMR element, there are a pseudo spin-valve type in which write/read is performed by utilizing the difference of coercive forces, and a spin-valve type in which a magnetization direction of one ferromagnetic layer is fixed through exchange coupling with antiferromagnetic layer. Data readout in the GMR element is performed by detecting a change of the resistance value of the first magnetic layer in the direction perpendicular to the lamination direction. Also, data write in the GMR element is performed by reversing the magnetization direction of one ferromagnetic layer by means of a magnetic field produced by a write current.

Further, the magnetic yoke according to the above embodiments is formed integrally from one end face to the other end face in the surrounding direction of the write wiring. As the shape of the magnetic yoke, other than the above, for example, shapes having one gap or more in the surrounding direction, thereby being divided into a plurality of portions, are applicable. Also, according to the above embodiments, the write switch means and the read switch means include transistors. As such switch means, it is possible to apply a variety of means providing current on/off functions depending on the need.

## Claims

1. A magnetic memory having a plurality of memory areas,
wherein each of said memory areas comprises:
a magnetoresistive effect element including a magnetosensitive layer of which magnetization direction is changed by an external magnetic field;
a write wiring for supplying the external magnetic field to the magnetosensitive layer by means of a write current;
a magnetic yoke surrounding said write wiring and having a pair of open end portions, wherein said magnetoresistive effect element is arranged between said open end portions,
a write switch means for controlling conduction of the write current in said write wiring.

2. The magnetic memory according to claim 1,
wherein the cross section area of the magnetic yoke perpendicular to the surrounding direction is the smallest at the pair of open end portions.

3. The magnetic memory according to claim 1,
wherein the easy-to-magnetize axis direction of said magnetic yoke runs along the easy-to-magnetize axis direction of the magnetosensitive layer.

4. The magnetic memory according to claim 1,
wherein a plurality of memory areas are arranged in a two-dimensional form constituted of m rows and n columns, wherein m is an integer of 2 or more and n is an integer of 2 or more, and wherein each of said memory area comprises:
a first wiring connected to said write wiring; and
a second wiring connected to a control terminal of said write switch means.

5. The magnetic memory according to claim 1, further comprising:
a write current generation means for supplying a positive and a negative write current to the write wiring.

6. The magnetic memory according to claim 1,
wherein each of a plurality of memory areas further comprises:
a readout wiring electrically connected to said magnetoresistive effect element, for making a readout current flow into said magnetoresistive effect element; and
a readout switch means for controlling conduction of the readout current in said readout wiring.

7. A magnetic memory having a plurality of memory areas,
wherein each of a plurality of memory areas comprises:
a magnetoresistive effect element including a magnetosensitive layer of which magnetization direction is changed by an external magnetic field;
a write wiring for supplying the external magnetic field to the magnetosensitive layer by means of a write current;
a magnetic yoke surround said write wiring; and
a write switch means for controlling conduction of the write current in said write wiring,
wherein said magnetosensitive layer of said magnetoresistive effect element is constituted of a portion of said magnetic yoke.

8. The magnetic memory according to claim 7,
wherein a plurality of memory areas are arranged in a two-dimensional form constituted of m rows and n columns, wherein m is an integer of 2 or more and n is an integer of 2 or more, and wherein each of said memory area comprises:
a first wiring connected to said write wiring; and
a second wiring connected to a control terminal of said write switch means.

9. The magnetic memory according to claim 7, further comprising:
a write current generation means for supplying a positive and a negative write current to the write wiring.

10. The magnetic memory according to claim 7,
wherein each of a plurality of memory areas further comprises:
a readout wiring electrically connected to said magnetoresistive effect element, for making a readout current flow into said magnetoresistive effect element; and
a readout switch means for controlling conduction of the readout current in said readout wiring.
